# EUROPÄISCHE PATENTSCHRIFT

(11) **EP 1 152 249 B1**
(45) Veröffentlichungstag und Bekanntmachung des Hinweises auf die Patenterteilung: **26.10.2005**
(21) Anmeldenummer: 01109241.8
(22) Anmeldetag: 14.04.2001
(51) Int. Cl.: G01R 31/36, G01R 31/02

(54) **Vorrichtung und Verfahren zur Erkennung einer Unterbrechung in der Ladeleitung zwischen einem Generator und einer elektrischen Batterie in einem Kraftfahrzeug**
Device and method for detecting an interruption in the charging line between a generator and a battery of a vehicle
Dispositif et procédé pour détecter une interruption dans la ligne de charge entre un générateur et une batterie d'un véhicule

(30) Priorität: 04.05.2000 DE 10021602
(43) Veröffentlichungstag der Anmeldung: 07.11.2001
(73) Patentinhaber: Bayerische Motoren Werke Aktiengesellschaft, 80809 München (DE)
(72) Erfinder: Pawlik, Peter, 83624 Otterfing (DE)

(56) Entgegenhaltungen:
- US-A- 4 242 674
- US-A- 4 459 548
- PATENT ABSTRACTS OF JAPAN vol. 1999, no. 02, 26. Februar 1999 (1999-02-26) & JP 10 304556 A (NISSIN ELECTRIC CO LTD), 13. November 1998 (1998-11-13)

## Beschreibung

Die Erfindung bezieht sich auf eine Vorrichtung und ein Verfahren zur Erkennung einer Unterbrechung in der Ladeleitung zwischen einem Generator und einer elektrischen Batterie in einem Kraftfahrzeug.

Kraftfahrzeuge, insbesondere mit einem 12 V Bordnetz, werden mittels eines geregelten Drehstromgenerators mit elektrischer Energie versorgt. Zum technischen Hintergrund von elektronischen Generatorreglern wird insbesondere auf das Fachbuch "Autoelektrik, Autoelektronik am Ottomotor", BOSCH, VDI-Verlag, 1994, hingewiesen. Elektronische Generatorregler werden heute vermehrt als eigenständige intelligente Steuergeräte, vorwiegend mit einer Datenverbindungsleitung zu anderen Steuergeräten, wie z. B. dem Brennkraftmaschinensteuergerät, entwickelt. Hierdurch sind im Vergleich mit früheren Generatorreglern erweiterte Funktionsumfänge im Generatorregler möglich. Beispielsweise wird zur Vermeidung von Drehmomentsprüngen bei einer Aufschaltung von großen elektrischen Verbrauchern die Abgabeleistung des Generators bis zu einer vorgegebenen Generatordrehzahl über eine definierte Rampe hochgeregelt (sog. Load Response Function, vgl. DE 196 38 357 A1). Weiterhin sind erweitere Diagnose- und Fehlererkennungsroutinen vorgesehen.

Eine Unterbrechung in der Ladeleitung vom Generator zur Batterie, wie beispielsweise ein Wackelkontakt aufgrund einer losen Verbindung, ist derzeit noch nicht erkennbar. Der Generator erkennt hierbei keinen Fehler, sondern lediglich, dass das Bordnetz keinen Strom benötigt. Als Folge wird die Erregung auf ein Minimum zurückgenommen oder zeitweise ganz abgeschaltet. Wird bei einem Wackelkontakt die Verbindung kurzzeitig wieder hergestellt, erkennt der Generator eine Lastzuschaltung und beginnt beispielsweise entsprechend der Load Response Function (LRF) die Generatorleistung hochzuregeln. Eine ständige Wiederholung dieses Vorganges führt zu einer permanenten Minderleistung des Generators und letztlich zur Entleerung der Fahrzeugbatterie. Dieses Fehlerbild ist in den Werkstätten derzeit nur schwer nachzuvollziehen und führt daher zu unnötigem Austausch von Batterien und Generatoren. Die Ladeleitung vom Generatorausgang bis zum Batterieanschluß besteht üblicherweise aus einer Vielzahl von einzelnen durch Steckverbindungen oder andere Verbindungen zusammengesetzten Teilleitungen. Der dargestellte Fehler ist daher keine Seltenheit.

Es ist Aufgabe der Erfindung, die Fehlerdiagnose in einem Generatorregler zu verbessern, um unnötige Service- und Teileaustauschkosten zu verhindern.

Diese Aufgabe wird durch die Merkmale des Patentanspruchs 1 bzw. 6 verfahrensmäßig bzw. vorrichtungsmäßig gelöst. Vorteilhafte Weiterbildungen der Erfindung sind die Gegenstände der abhängigen Ansprüche.

Erfindungsgemäß wird eine Unterbrechung, z. B. in Form eines Wackelkontaktes oder in Form einer Dauerunterbrechung, in der Ladeleitung zwischen einem Generator und einer elektrischen Batterie in einem Kraftfahrzeug erkannt, wenn die Oberwelligkeit der Generatorausgangsspannung bzw. die Oberwelligkeitsspannung, vorzugsweise deren Mittelwert über eine vorgegebene Zeitspanne, einen vorgegeben Oberwelligkeitsschwellwert, vorzugsweise nach einer vorgegebenen oder für eine vorgegebene Zeitdauer (z. B. 2 ms), erreicht oder überschritten hat. Der Oberwelligkeitsschwellwert (ca. >3V oder Erhöhung um Faktor 2) kann beispielsweise fest oder variabel abhängig von der Generator-Drehzahl und/oder dem Generator-Strom vorgegeben werden. Die Oberwelligkeit bzw. die Oberwelligkeitsspannung ist der Spannungswert zwischen einem Maximum und einem Minimum der verbleibenden Signalschwingungen in der Generatorausgangsspannung nach der Gleichrichtung der von einem Drehstromgenerator erzeugten Ausgangsspannung.

Der Erfindung liegt die Erkenntnis zugrunde, daß die Oberwelligkeitsspannung bei einer intakten Ladeleitung zwischen Generator und Batterie sehr klein ist, da die Signalschwingungen durch die wie ein Kondensator wirkende Batterie geglättet werden. Diese Glättungswirkung der Batterie entfällt, wenn die Ladeleitung unterbrochen ist.

Vorzugsweise wird eine Unterbrechung in der Ladeleitung erkannt, wenn die Oberwelligkeitsspannung einen vorgegeben Oberwelligkeitsschwellwert erreicht oder überschritten hat, nachdem die Generatorausgangsspannung einen vorgegebenen Lastabwurfschwellwert (z. B. 18V bei einem 12 V Bordnetz) erreicht oder überschritten hat. Dieser Weiterbildung der Erfindung liegt die Erkenntnis zugrunde, daß der Übergang von einer intakten zu einer unterbrochenen Ladeleitung entsprechend einem Lastabwurf zunächst zu einem Spannungsüberschwinger führt. Die erfindungsgemäße Auswertung der Oberwelligkeitsspannung im Hinblick auf einen Oberwelligkeitsschwellwert findet demnach erst statt, wenn dieser Spannungsüberschwinger aufgetreten ist. Dabei muß schaltungstechnisch darauf geachtet werden, daß auch nur sehr kurze Spannungsüberschwinger (z. B. für 0,1 ms) erkannt werden. Hierdurch wird die Fehlererkennungsgenauigkeit erhöht.

Weiterhin wird vorzugsweise auf eine Unterbrechung in der Ladeleitung erst dann geschlossen, wenn ein Fehler in der Endstufe zur Ansteuerung der Erregerspule ausgeschlossen ist. Denn bei einem Fehler in dieser Endstufe, insbesondere bei einer leitend legierte Endstufe, erzeugt der Generator Überspannungen (z. B. bis zu 20 V bei einer Nennspannung von 12V) und liefert damit Ströme über die Nennleistung hinaus, wodurch ebenfalls eine größere Oberwelligkeitsspannung entsteht. Erfindungsgemäß muß diese Bedingung daher berücksichtigt werden, um eine fehlerhafte Fehlererkennung auszuschließen.

Weiterhin wird vorzugsweise eine Unterbrechung in der Ladeleitung bei Vorliegen der oben genannten Bedingung auch nur dann erkannt, wenn die Erregung in der Erregerspule kleiner als 100% ist. Dieser Bedingung liegt die Erkenntnis zugrunde, daß bei Unterbrechung der Ladeleitung aus Sicht des Generators bzw. Generatorreglers zunächst derselbe Zustand vorliegt, wie bei fehlender Stromanforderung des Bordnetzes mit intakter Ladeleitung. Dieser Zustand kann im fehlerfreien Fall auftreten, wenn z. B. die Batterie ausreichend geladen und nur wenige Verbraucher eingeschaltet sind. Bei diesem Zustand schaltet üblicherweise der Generatorregler die Einschaltdauer der Erregerspulen-Endstufe automatisch auf ein Minimum (sog. Prüfpulsbreite).

Da die Oberwelligkeit bzw. die Oberwelligkeitsspannung insbesondere von der Generatordrehzahl und dem abgegebenen Strom abhängt, wird der Oberwelligkeitsschwellwert vorzugsweise variabel angepaßt an diese Einflußgrößen vorgegeben. Eine möglichst einfache Anpassung dieses Oberwelligkeitsschwellwertes findet durch ff. Weiterbildung der Erfindung statt: Bevor die Generatorausgangsspannung den vorgegebenen Lastabwurfschwellwert erreicht oder überschritten hat, wird vorzugsweise ständig ein gleitender Mittelwert der Oberwelligkeitsspannung gebildet. Denn auch bei intakter Ladeleitung tritt eine Rest-Oberwelligkeit auf, da die Batterie die gleichgerichtete Drehstromspannung des Generators nicht zu 100 % glätten kann. Der jeweilige Oberwelligkeitsschwellwert ist dann der momentan gültige Mittelwert der Oberwelligkeitsspannung zum Zeitpunkt des Erreichens oder Überschreitens des Lastabwurfschwellwerts durch die Generatorausgangsspannung.

Das erfindungsgemäße Verfahren wird vorzugsweise als Softwareerweiterung in einen ohnehin vorhandenen Generatorregler bzw. in ein ohnehin vorhandenes Generatorregelsteuergerät integriert.

Durch diese Erfindung wird eine hochgenaue qualifizierte Fehlererkennung ermöglicht.

In der Zeichnung ist ein Ausführungsbeispiel der Erfindung dargestellt. Es zeigt
- Fig. 1: die für das Verständnis der Erfindung erforderlichen Bestandteile eines Generators, eines Generatorreglers und eines Bordnetzes,
- Fig. 2: den Verlauf der Generatorausgangsspannung vor und nach einer Unterbrechung in der Ladeleitung und
- Fig. 3: einen möglichen Ablaufplan eines erfindungsgemäßen Verfahrens.

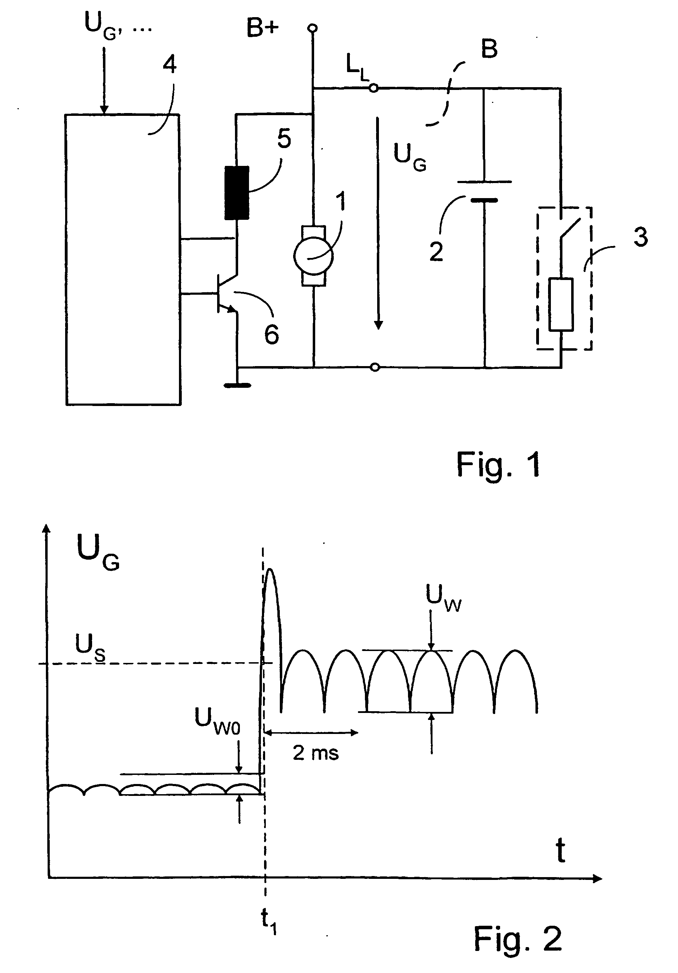

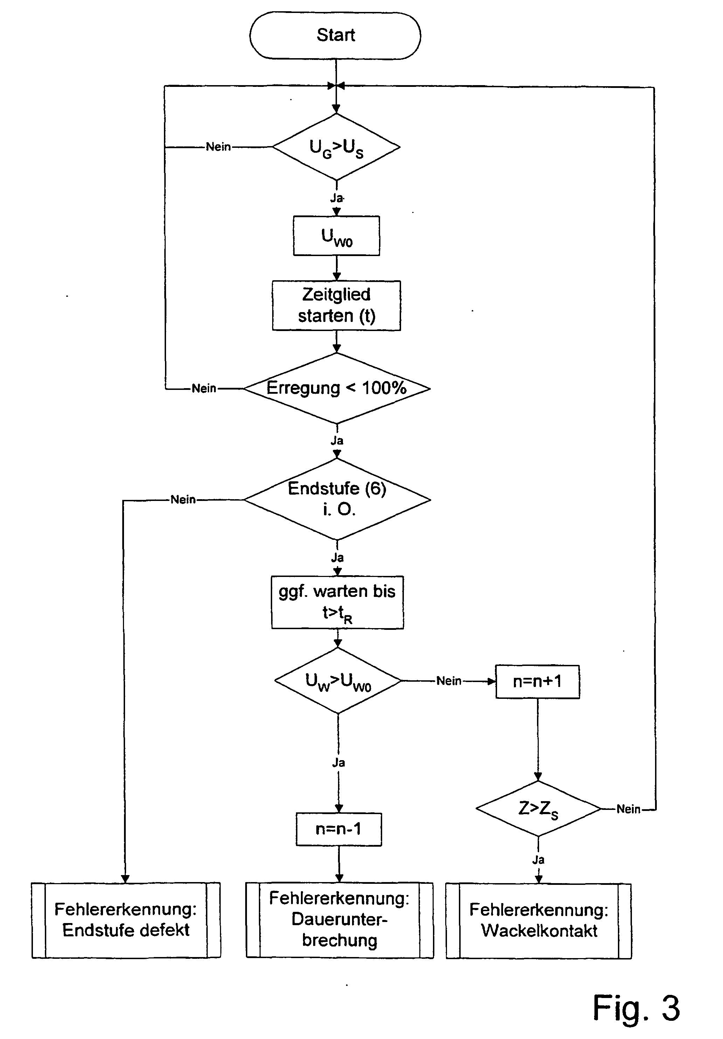

In Fig. 1 ist zu einem Generator 1 eine Batterie 2 parallelgeschaltet. Eine Ladeleitung L_{L} verbindet den Generatorausgang B+ mit dem Plus-Anschluß der Batterie 2 eines hier nicht dargestellten Kraftfahrzeuges. Parallel zur Batterie 2 sind symbolisch mit einem Widerstand 3 zu- und abschaltbare elektrische Verbraucher eines Kraftfahrzeuges dargestellt. Dem Generator 1 ist ein intelligenter Generatorregler 4 zugeordnet. Der Generatorregler 4 ist zumindest über eine Ansteuerleitung mit der Basis und über eine Rückführleitung mit dem Kollektor eines Transistors 6, im ff. kurz Endstufe 6 genannt, zur Bestromung der Erregerspule 5 verbunden. Weiterhin erhält der Generatorregler 4 zumindest die Generatorausgangsspannung U_{G} als Eingangssignal. Der erfindungsgemäße Funktionsumfang ist als Software im Generatorregler 4 integriert und wird im Zusammenhang mit den Figuren 2 und 3 erläutert.

In Fig. 2 ist die Generatorausgangsspannung U_{G} über der Zeit t aufgetragen. Zunächst sei die Ladeleitung L_{L} bis zum Zeitpunkt t1 intakt. Vor dem Zeitpunkt t1 liegt der Absolutwert der Generatorausgangsspannung U_{G} deutlich unterhalb eines definierten Lastabwurfschwellwertes U_{S}, der beispielsweise bei einem 12 V Bordnetz 18 V sein kann. Die Oberwelligkeitsspannung U_{W} ist sehr gering. Es wird vor dem Zeitpunkt t1 ständig ein gleitender Mittelwert der Oberwelligkeitsspannung U_{W} gebildet, der zum Zeitpunkt t1 als Oberwelligkeitsschwellwertes U_{W0} übernommen wird. Zum Zeitpunkt t1 trete eine länger andauernde Unterbrechung B in der Ladeleitung L_{L} auf. Folge der Unterbrechung B ist ein Spannungsüberschwinger zum Zeitpunkt t1, durch den die Generatorausgangsspannung U_{G} den Lastabwurfschwellwert U_{S} überschreitet. Daraufhin folgt eine deutliche Erhöhung der Oberwelligkeitsspannung U_{W}. Die Oberwelligkeitsspannung U_{W} überschreitet, erfahrungsgemäß spätestens nach 2 ms, den Oberwelligkeitsschwellwert U_{W0}.

Im Generatorregler 4 wird die Generatorausgangsspannung U_{B} erfaßt. Die Generatorausgangsspannung U_{B} wird im Hinblick auf die Erfassung der Oberwelligkeitsspannung U_{W} und der Ermittlung des gleitenden Mittelwertes der Oberwelligkeitsspannung U_{W} weiterverarbeitet. Weiterhin findet im Generatorregler 4, z. B. entsprechend dem Stand der Technik, eine Diagnose der Endstufe 6 statt. Beispielsweise über das Tastverhältnis des Ansteuersignals der Endstufe 6 wird die Höhe der Erregung festgestellt. Zum Vergleich der Generatorausgangsspannung U_{B} mit dem in einem Speicher vorgegebenen Lastabwurfschwellwert U_{S} ist im Generatorregler 4 beispielsweise ein Schwellwertkomparator vorgesehen, der auch sehr kurze Schwellwertüberschreitungen (z. B. < 0,1 ms) erfassen kann.

Das erfindungsgemäße Verfahren wird an Hand der Fig. 3 beschrieben. Zunächst wird die Generatorausgangsspannung U_{B} mit dem Lastabwurfschwellwert U_{S} verglichen. Hat die Generatorausgangsspannung U_{B}, wenn auch nur kurzzeitig, den Lastabwurfschwellwert U_{S} überschritten, wird der momentan gültige, bis zum Zeitpunkt t1 gebildete gleitende Mittelwert der Oberwelligkeitsspannung U_{W0} als Oberwelligkeitsschwellwert definiert und gespeichert. Im nächsten Schritt wird ein Zeitglied zur Erfassung der Zeit t nach dem Zeitpunkt t1 gestartet. Danach wird geprüft, wie hoch die Erregung ist. Ist die Erregung zumindest kleiner als 100% wird das Ergebnis der Endstufen-Diagnose abgefragt. Wenn die Endstufe 6 (vgl. Fig.1) in Ordnung ist (i. O.), wird geprüft, ob die mittels des Zeitgliedes erfaßte Zeit t größer als eine vorgegebene Zeitspanne t_{R} (z. B. 2 ms) ist. Die Oberwelligkeitsspannung U_{W} wird frühestens nach Ablauf dieser vorgegebenen Zeitspanne t_{R} nach t1 mit dem Oberwelligkeitsschwellwert U_{W0} verglichen. Für diesen Vergleich kann der Absolutwert zwischen dem Minimum und dem Maximum jeder Schwingung oder aber auch ein für eine kurze Zeit gebildeter Mittelwert der Oberwelligkeitsspannung U_{W} verwendet werden.

Wenn die Oberwelligkeitsspannung U_{W} den Oberwelligkeitsschwellwert U_{W0} nicht überschritten hat, wird ein Zähler inkrementiert (n=n+1). Der Zählerstand Z wird mit einem definierten Grenzwert Z_{S} (z. B. 5) verglichen. Wenn dieser Grenzwert Z_{S} überschritten wird, schließt der Generatorregler 4 auf sporadische Unterbrechung, also Wackelkontakt, in der Ladeleitung L_{L}.

Wenn die Oberwelligkeitsspannung U_{W} den Oberwelligkeitsschwellwert U_{W0} überschritten hat, wird der Zähler dekrementiert (n=n-1) und der Generatorregler 4 schließt auf Dauerunterbrechung der Ladeleitung L_{L}. Die entsprechende Fehlererkennung kann in einem Fehlerspeicher abgelegt und in der Werkstatt abgerufen werden.

## Patentansprüche

1. Verfahren zur Erkennung einer Unterbrechung (B) in der Ladeleitung (L_{L}) zwischen einem Generator (1) und einer elektrischen Batterie (2) in einem Kraftfahrzeug, bei dem die Generatorausgangsspannung (U_{G}) gemessen und zumindest im Hinblick auf die Oberwelligkeitsspannung (U_{W}) ausgewertet wird und bei dem eine Unterbrechung (B) in der Ladeleitung (L_{L}) erkannt wird, wenn die Oberwelligkeitsspannung (U_{W}) einen vorgegeben Oberwelligkeitsschwellwert (U_{W0}) erreicht oder überschritten hat.

2. Verfahren nach Patentanspruch 1, **dadurch gekennzeichnet, daß** eine Unterbrechung (B) in der Ladeleitung (L_{L}) erkannt wird, wenn die Oberwelligkeitsspannung (U_{W}) einen vorgegeben Oberwelligkeitsschwellwert (U_{W0}) erreicht oder überschritten hat, nachdem die Generatorausgangsspannung (U_{G}) einen vorgegebenen Lastabwurfschwellwert (U_{S}) erreicht oder überschritten hat.

3. Verfahren nach Patentanspruch 2, **dadurch gekennzeichnet, daß** eine Unterbrechung (B) in der Ladeleitung (L_{L}) nur dann erkannt wird, wenn ein Fehler in der Endstufe (6) zur Ansteuerung der Erregerspule (5) ausgeschlossen ist.

4. Verfahren nach Patentanspruch 2 oder 3, **dadurch gekennzeichnet, daß** eine Unterbrechung (B) in der Ladeleitung (L_{L}) nur dann erkannt wird, wenn die Erregung in der Erregerspule (5) kleiner als 100% ist.

5. Verfahren nach einem der Patentansprüche 1 bis 4 **dadurch gekennzeichnet, daß** ein gleitender Mittelwert der Oberwelligkeitsspannung gebildet wird, bevor die Generatorausgangsspannung (U_{G}) den vorgegebenen Lastabwurfschwellwert (U_{S}) erreicht oder überschritten hat, und daß der Oberwelligkeitsschwellwert (U_{W0}) dem momentan gültigen Mittelwert (U_{W0}) der Oberwelligkeitsspannung (U_{W}) zum Zeitpunkt (t1) des Erreichens oder Überschreitens des Lastabwurfschwellwertes (U_{S}) durch die Generatorausgangsspannung (U_{G}) gleichgesetzt wird.

6. Vorrichtung zur Durchführung des Verfahrens nach einem der Patentansprüche 1 bis 5 zur Erkennung einer Unterbrechung (B) in der Ladeleitung (L_{L}) zwischen einem Generator (1) und einer elektrischen Batterie (2) in einem Kraftfahrzeug, bei der Mittel vorgesehen sind, durch die die Generatorausgangsspannung (U_{G}) gemessen und zumindest im Hinblick auf die Oberwelligkeitsspannung (U_{W}) ausgewertet wird und bei der Mittel vorgesehen sind, durch die eine Unterbrechung (B) in der Ladeleitung (L_{L}) erkannt wird, wenn die Oberwelligkeitsspannung (U_{W}) einen vorgegeben Oberwelligkeitsschwellwert (U_{W0}) erreicht oder überschritten hat.

7. Vorrichtung nach Patentanspruch 6, **dadurch gekennzeichnet, daß** Mittel vorgesehen sind, durch die eine Unterbrechung (B) in der Ladeleitung (L_{L}) erkannt wird, wenn die Oberwelligkeitsspannung (U_{W}) einen vorgegeben Oberwelligkeitsschwellwert (U_{W0}) erreicht oder überschritten hat, nachdem die Generatorausgangsspannung (U_{G}) einen vorgegebenen Lastabwurfschwellwert (U_{S}) erreicht oder überschritten hat.

8. Vorrichtung nach Patentanspruch 7, **dadurch gekennzeichnet, daß** Mittel vorgesehen sind, durch die eine Unterbrechung (B) in der Ladeleitung (L_{L}) nur dann erkannt wird, wenn ein Fehler in der Endstufe (6) zur Ansteuerung der Erregerspule (5) ausgeschlossen ist.

9. Vorrichtung nach Patentanspruch 8 oder 9, **dadurch gekennzeichnet, daß** Mittel vorgesehen sind, durch die eine Unterbrechung (B) in der Ladeleitung (L_{L}) nur dann erkannt wird, wenn die Erregung in der Erregerspule (5) kleiner als 100% ist.

10. Vorrichtung nach einem der Patentansprüche 6 bis 9 **dadurch gekennzeichnet, daß** Mittel vorgesehen sind, durch die ein gleitender Mittelwert der Oberwelligkeitsspannung gebildet wird, bevor die Generatorausgangsspannung (U_{G}) den vorgegebenen Lastabwurfschwellwert (U_{S}) erreicht oder überschritten hat, und daß Mittel vorgesehen sind, durch die der Oberwelligkeitsschwellwert (U_{W0}) dem momentan gültigen Mittelwert (U_{W0}) der Oberwelligkeitsspannung (U_{W}) zum Zeitpunkt (t1) des Erreichens oder Überschreitens des Lastabwurfschwellwertes (U_{S}) durch die Generatorausgangsspannung (U_{G}) gleichgesetzt wird.

## Claims

1. A method of detecting a break (B) in the charging line (L_{L}) between a generator (1) and a battery (2) in a vehicle, wherein the generator output voltage (U_{G}) is measured and evaluated at least with respect to the harmonic voltage (U_{W}) and wherein a break (B) in the charging line (L_{L}) is detected if the harmonic voltage (U_{W}) has reached or exceeded a set harmonic threshold (U_{WO}).

2. A method according to claim 1, **characterised in that** a break (B) in the charging line (L_{L}) is detected if the harmonic voltage (U_{W}) has reached or exceeded a set harmonic threshold (U_{WO}) after the generator output voltage (U_{G}) has reached or exceeded a set load-shedding threshold (U_{S}).

3. A method according to claim 2, **characterised in that** a break (B) in the charging line (L_{L}) is detected only when a fault in the end stage (6) for actuating the exciting coil (5) has been ruled out.

4. A method according to claim 2 or 3, **characterised in that** a break (B) in the charging line (L_{L}) is detected only if the excitation in the exciting coil (5) is less than 100%.

5. A method according to any of claims 1 to 4, **characterised in that** a sliding average value of the harmonic voltage is obtained before the generator output voltage (U_{G}) has reached or exceeded the set load-shedding threshold (U_{S}) and the harmonic threshold (U_{WO}) is equated with the instantaneously valid average value (U_{WO}) of the harmonic voltage (Uw) at the time (t1) when the load-shedding threshold (U_{S}) is reached or exceeded by the generator output voltage (U_{G}).

6. A device for working the method according to any of claims 1 to 5 for detecting a break (B) in the charging line (L_{L}) between a generator (1) and a battery (2) in a vehicle, wherein means are provided whereby the generator output voltage (U_{G}) is measured and evaluated at least with respect to the harmonic voltage (U_{W}) and wherein means are provided whereby a break (B) in the charging line (L_{L}) is detected when the harmonic voltage (U_{W}) has reached or exceeded a set harmonic threshold (U_{WO}).

7. A device according to claim 6, **characterised in that** means are provided whereby a break (B) in the charging line (L_{L}) is recognised when the harmonic voltage (U_{W}) has reached or exceeded a set harmonic threshold (U_{WO}) after the generator output voltage (U_{G}) has reached or exceeded a set load-shedding threshold (U_{S}).

8. A device according to claim 7, **characterised in that** means are provided whereby a break (B) in the charging line (L_{L}) is detected only when a fault in the end stage (6) for actuating the exciting coil (5) has been ruled out.

9. A device according to claim 8 or 9, **characterised in that** means are provided whereby a break (B) in the charging line (L_{L}) is detected only when the excitation in the exciting coil (5) is less than 100%.

10. A device according to any of claims 6 to 9, **characterised in that** means are provided whereby a sliding average value of the harmonic voltage is obtained before the generator output voltage (U_{G}) has reached or exceeded the set load-shedding threshold (U_{S}) and means are provided whereby the harmonic threshold (U_{WO}) is equated with the instantaneously valid average value (U_{WO}) of the harmonic voltage (U_{W}) at the time (t1) when the load-shedding threshold (U_{S}) is reached or exceeded by the generator output voltage (U_{G}).

## Revendications

1. Procédé pour détecter une interruption (B) dans la ligne de charge (L_{L}) reliant un générateur (1) et une batterie électrique (2) d'un véhicule automobile, selon lequel la tension de sortie de générateur (U_{G}) est évaluée au moins en ce qui concerne la tension d'ondulation (Uw) et une interruption (B) dans la ligne (L_{L}) est détectée si la tension d'oscillation (Uw) a atteint ou dépassé une valeur de seuil d'oscillation (U_{W0}) prédéfinie.

2. Procédé selon la revendication 1,
**caractérisé en ce qu'**
une interruption (B) dans la ligne de charge (L_{L}) est détectée si la tension d'ondulation (Uw) a atteint ou dépassé une valeur de seuil d'oscillation (U_{WO}) prédéfinie après que la tension de sortie de générateur (U_{G}) ait atteint ou dépassé une valeur de seuil de délestage (Us) prédéfinie.

3. Procédé selon la revendication 2,
**caractérisé en ce qu'**
une interruption (B) dans la ligne de charge (L_{L}) est détectée seulement si un défaut dans l'étage final (6) servant à commander la bobine d'excitation (5) est exclu.

4. Procédé selon la revendication 2 ou 3,
**caractérisé en ce qu'**
une interruption (B) dans la ligne de charge (L_{L}) est détectée seulement si l'excitation dans la bobine d'excitation (5) est inférieure à 100 %.

5. Procédé selon une des revendications 1 à 4,
**caractérisé en ce qu'**
une valeur moyenne glissante de la tension d'oscillation est établie avant que la sortie de tension de générateur (U_{G}) ait atteint ou dépassé la valeur de seuil de délestage (U_{S}) prédéfinie, et la valeur de seuil d'ondulation (U_{W0}) est placée au niveau de la valeur moyenne (U_{W0}), valable à l'instant (t1) où la valeur de seuil de délestage est atteinte (U_{W}) ou dépassée par la tension de sortie (U_{G}) du générateur.

6. Dispositif pour la mise en oeuvre du procédé selon une des revendications 1 à 5, servant à détecter une interruption (B) dans la ligne de charge (L_{L}) reliant un générateur (1) et une batterie électrique (2) dans un véhicule automobile, dispositif dans lequel sont prévus des moyens par lesquels la tension de sortie (U_{G}) du générateur est mesurée et exploitée au moins en ce qui concerne la tension d'ondulation (U_{W}), ainsi que des moyens par lesquels l'interruption (B) dans la ligne de charge (L_{L}) est détectée si la tension d'oscillation (Uw) a atteint ou dépassé une valeur de seuil d'oscillation (U_{W0}) prédéfinie.

7. Dispositif selon la revendication 6,
**caractérisé en ce qu'**
il est prévu des moyens par lesquels est détectée une interruption (B) dans la ligne de charge (L_{L}) si la tension d'ondulation (Uw) a atteint ou dépassé une valeur de seuil d'oscillation (U_{W0}) prédéfinie, après que la tension de sortie de générateur (U_{G}) ait atteint ou dépassé une valeur de seuil de délestage (Us) prédéfinie.

8. Dispositif selon la revendication 7,
**caractérisé en ce qu'**
il est prévu des moyens par lesquels une interruption (B) dans la ligne de charge (L_{L}) est détectée seulement si un défaut dans l'étage final (6) servant à commander la bobine d'excitation (5) est exclu.

9. Dispositif selon la revendication 8,
**caractérisé en ce qu'**
il est prévu des moyens par lesquels une interruption (B) dans la ligne de charge (L_{L}) est détectée seulement si l'excitation dans la bobine d'excitation (5) est inférieure à 100 %.

10. Dispositif selon une des revendications 6 à 9,
**caractérisé en ce qu'**
il est prévu des moyens par lesquels une valeur moyenne glissante de la tension d'oscillation est établie avant que la sortie de tension de générateur (U_{G}) ait atteint ou dépassé la valeur de seuil de délestage (Us) prédéfinie, et la valeur de seuil d'ondulation (U_{W0}) est placée au niveau de la valeur moyenne (U_{W0}), valable à l'instant (t1) où la valeur de seuil de délestage (Us) est atteinte ou dépassée par la tension de sortie (U_{G}) du générateur.
